(19) Europäisches Patentamt
European Patent Office
Office européen des brevets

(11) **EP 4 074 678 B1**

(12) **EUROPEAN PATENT SPECIFICATION**

(45) Date of publication and mention
of the grant of the patent:
**18.12.2024 Bulletin 2024/51**

(21) Application number: **20897945.0**

(22) Date of filing: **12.10.2020**

(51) International Patent Classification (IPC):
*C04B 37/02* (2006.01)   *H01L 23/15* (2006.01)
*H01L 23/373* (2006.01)   *H05K 1/03* (2006.01)
*H05K 3/38* (2006.01)   *H01L 23/36* (2006.01)

(52) Cooperative Patent Classification (CPC):
**H01L 23/3735; C04B 37/026; H05K 1/0306;**
**H05K 3/38;** C04B 2235/85; C04B 2235/96;
C04B 2237/125; C04B 2237/127; C04B 2237/343;
C04B 2237/366; C04B 2237/407; C04B 2237/60;
C04B 2237/704; C04B 2237/706; H01L 23/36;

(Cont.)

(86) International application number:
**PCT/JP2020/038489**

(87) International publication number:
**WO 2021/117327 (17.06.2021 Gazette 2021/24)**

(54) **COPPER/CERAMIC ASSEMBLY AND INSULATED CIRCUIT BOARD**

KUPFER-/KERAMIKANORDNUNG UND ISOLIERTE LEITERPLATTE

ENSEMBLE CUIVRE/CÉRAMIQUE ET CARTE DE CIRCUIT IMPRIMÉ ISOLÉE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **12.12.2019   JP 2019224214**
**06.10.2020   JP 2020169086**

(43) Date of publication of application:
**19.10.2022 Bulletin 2022/42**

(73) Proprietor: **Mitsubishi Materials Corporation**
**Tokyo 100-8117 (JP)**

(72) Inventor: **TERASAKI, Nobuyuki**
**Saitama-shi, Saitama 330-8508 (JP)**

(74) Representative: **Hoffmann Eitle**
**Patent- und Rechtsanwälte PartmbB**
**Arabellastraße 30**
**81925 München (DE)**

(56) References cited:
**JP-A- 2013 058 535      JP-A- 2015 092 552**
**JP-A- H0 513 920        JP-A- H0 597 533**
**JP-A- H0 624 854        JP-A- H0 624 854**
**JP-A- H04 290 462       JP-A- H05 148 053**
**US-A1- 2016 221 305**

(52) Cooperative Patent Classification (CPC): (Cont.)
H01L 2224/32225

**Description**

TECHNICAL FIELD

The present invention relates to a copper/ceramic bonded body in which a copper member made of copper or a copper alloy and a ceramic member made of aluminum-containing ceramics are bonded to each other, and an insulating circuit substrate in which a copper sheet made of copper or a copper alloy is bonded to a surface of a ceramic substrate made of aluminum-containing ceramics.
The present application claims priority on Japanese Patent Application No. 2019-224214 filed on December 12, 2019, and Japanese Patent Application No. 2020-169086 filed on October 6, 2020,

BACKGROUND ART

A power module, an LED module, and a thermoelectric module have a structure in which a power semiconductor element, an LED element, and a thermoelectric element are bonded to an insulating circuit substrate, and in the insulating circuit substrate, a circuit layer made of a conductive material is formed on one surface of an insulating layer.
For example, a power semiconductor element for high-power control used for controlling a wind power generation, an electric vehicle, a hybrid vehicle, or the like has a large amount of heat generated during operation. Therefore, as a substrate on which the power semiconductor element is mounted, an insulating circuit substrate including a ceramic substrate and a circuit layer formed by bonding a metal plate having excellent conductivity to one surface of the ceramic substrate has been widely used in the related art. As the insulating circuit substrate, one having a metal layer formed by bonding a metal plate to the other surface of the ceramic substrate is also provided.
Patent Document 1 proposes a substrate for a power module in which a first metal plate and the second metal plate constituting a circuit layer and a metal layer are made of a copper sheet, and the copper sheet is directly bonded to a ceramic substrate by a DBC method. In this DBC method, the copper sheet and the ceramic substrate are bonded to each other by forming a liquid phase at an interface between the copper sheet and the ceramic substrate by using a eutectic reaction of copper with a copper oxide.
Patent Document 2 proposes an insulating circuit substrate in which a circuit layer and a metal layer are formed by bonding a copper sheet to each of one surface and the other surface of a ceramic substrate. In Patent Document 2, the copper sheet is disposed on each of one surface and the other surface of the ceramic substrate with an Ag-Cu-Ti-based brazing material interposed therebetween, and the copper sheet is bonded thereto by performing a heating treatment (so-called active metal brazing method). In the active metal brazing method, since the brazing material containing Ti as an active metal is used, the wettability between the molten brazing material and the ceramic substrate is improved, and the ceramic substrate and the copper sheet are satisfactorily bonded to each other.
Patent Document 3 proposes a substrate for a power module in which a copper sheet made of copper or a copper alloy and a ceramic substrate made of AlN or $Al_2O_3$ are bonded to each other by using a bonding material containing Ag and Ti, and in which Ag particles are dispersed in a Ti compound layer formed at a bonded interface between the copper sheet and the ceramic substrate. Patent Document 4 discloses a copper/ceramic bonded body with an active metal compound interface layer between a copper member and a ceramic member.

PRIOR ART DOCUMENTS

Patent Document

    Patent Document 1: Japanese Unexamined Patent Application, First Publication No. H04-162756
    Patent Document 2: Japanese Patent No. 3211856
    Patent Document 3: Japanese Patent No. 5757359 Patent Document 4: US
    Patent Application US 2016/221305 A1

DISCLOSURE OF INVENTION

Problems to be Solved by the Invention

However, as disclosed in Patent Document 1, when the ceramic substrate and the copper sheet are bonded to each other by the DBC method, a bonding temperature needs to be set to 1065°C or higher (equal to or higher than eutectic point temperature of copper and copper oxide), so that there is a concern that the ceramic substrate deteriorates during bonding.

As disclosed in Patent Document 2, when the ceramic substrate and the copper sheet are bonded to each other by the active metal brazing method, a bonding temperature is set to a relatively high temperature of 900°C, so that there is a problem that the ceramic substrate deteriorates.

In Patent Document 3, since a copper member made of copper or a copper alloy and a ceramic member made of AlN or $Al_2O_3$ are bonded to each other by using the bonding material containing Ag and Ti, the ceramic member and the copper member can be bonded to each other under a relatively low temperature condition, and deterioration of the ceramic member during bonding can be suppressed.

Recently, depending on the application of the insulating circuit substrate, a thermal cycle that is more severe than in the related art is loaded.

Therefore, there is a demand for an insulating circuit substrate that has a high bonding strength and does not cause cracks even during loading of a thermal cycle, even in an application where a thermal cycle that is more severe than in the related art is loaded.

The present invention has been made in view of the above-described circumstances, and an objective of the present invention is to provide a copper/ceramic bonded body and an insulating circuit substrate, which have a high bonding strength and particularly excellent reliability of a thermal cycle.

Solutions for Solving the Problems

In order to solve the above-described problem, a copper/ceramic bonded body according to one aspect of the present invention (hereinafter, referred to as a "copper/ceramic bonded body according to the present invention") includes a copper member made of copper or a copper alloy, and a ceramic member made of aluminum-containing ceramics, the copper member and the ceramic member are bonded to each other, in which, at a bonded interface between the copper member and the ceramic member, an active metal compound layer containing a compound of one or more active metals selected from Ti, Zr, Nb, and Hf is formed on a ceramic member side, and in the active metal compound layer, Al and Cu are present at a grain boundary of the active metal compound.

According to the copper/ceramic bonded body according to the present invention, in the active metal compound layer formed at the bonded interface between the copper member and the ceramic member, Al and Cu are present at the grain boundary of the active metal compound, so that the active metal contained in a bonding material sufficiently reacts with the ceramic member, and the ceramic member and the copper member are firmly bonded to each other. Since the active metal is sufficiently diffused to the ceramic member side via a liquid phase (Al-Cu eutectic liquid phase) formed during the reaction, a sufficient interfacial reaction can be promoted, and the ceramic member and the copper member can be firmly bonded to each other. Accordingly, reliability of a thermal cycle can be improved.

From the above, according to the copper/ceramic bonded body according to the present invention, it is possible to obtain a copper/ceramic bonded body having a high bonding strength and particularly excellent reliability of a thermal cycle.

In the copper/ceramic bonded body according to the present invention, it is preferable that in the active metal compound layer, Ag is present at the grain boundary of the active metal compound.

In this case, an Al-Ag-Cu eutectic liquid phase is present during the reaction. The Al-Ag-Cu eutectic has a lower eutectic temperature than Al-Cu eutectic, the Al-Ag-Cu eutectic lowers the energy of the system and thus further promotes the reaction.

In the copper/ceramic bonded body according to the present invention, a maximum indentation hardness in a region from 10 $\mu$m to 50 $\mu$m from the bonded interface between the copper member and the ceramic member to a copper member side is in a range of 70 mgf/$\mu$m$^2$ or more and 135 mgf/$\mu$m$^2$ or less.

In this case, since the maximum indentation hardness in the region from 10 $\mu$m to 50 $\mu$m from the bonded interface between the copper member and the ceramic member to the copper member side is set to 70 mgf/$\mu$m$^2$ or more, the copper at or in the vicinity of the bonded interface is sufficiently melted during bonding, to form a liquid phase, and the ceramic member and the copper member are firmly bonded to each other. On the other hand, since the maximum indentation hardness in the above-described region is suppressed to 135 mgf/$\mu$m$^2$ or less, the vicinity of the bonded interface is not harder than necessary, and the generation of cracks during loading of the thermal cycle can be suppressed.

In the copper/ceramic bonded body according to the present invention, it is preferable that the active metal is Ti.

In this case, a titanium nitride layer or a titanium oxide layer is formed as the active metal compound layer at the bonded interface between the ceramic member and the copper member, and the ceramic member and the copper member can be firmly bonded to each other.

In the copper/ceramic bonded body according to the present invention, it is preferable that a maximum particle size of particles of the active metal compound in the active metal compound layer is 180 nm or less.

In this case, a proportion of a grain boundary region (metal phase) having a relatively low hardness in the active metal compound layer increases, and impact resistance of the active metal compound layer is improved. As a result, it is possible to suppress the generation of cracks in the active metal compound layer, and to suppress peeling of the copper member and the ceramic member and the generation of cracks in the ceramic member.

An insulating circuit substrate according to another aspect of the present invention (hereinafter, referred to as an "insulating circuit substrate according to the present invention") includes a copper sheet made of copper or a copper alloy, and a ceramic substrate made of aluminum-containing ceramics, the copper sheet is bonded to a surface of the ceramic substrate, in which, at a bonded interface between the copper sheet and the ceramic substrate, an active metal compound layer containing a compound of one or more active metals selected from Ti, Zr, Nb, and Hf is formed on a ceramic substrate side, and in the active metal compound layer, Al and Cu are present at a grain boundary of the active metal compound.

According to the insulating circuit substrate according to the present invention, in the active metal compound layer formed at the bonded interface between the copper sheet and the ceramic substrate, Al and Cu are present at the grain boundary of the active metal compound, so that the active metal contained in a bonding material sufficiently reacts with the ceramic substrate, and the ceramic substrate and the copper sheet are firmly bonded to each other. Since the active metal is sufficiently diffused to the ceramic substrate side via a liquid phase (Al-Cu eutectic liquid phase) formed during the reaction, a sufficient interfacial reaction can be promoted, and the ceramic substrate and the copper sheet can be firmly bonded to each other. Accordingly, reliability of a thermal cycle can be improved.

From the above, according to the insulating circuit substrate according to the present invention, it is possible to obtain an insulating circuit substrate having a high bonding strength and particularly excellent reliability of a thermal cycle.

In the insulating circuit substrate according to the present invention, it is preferable that in the active metal compound layer, Ag is present at the grain boundary of the active metal compound.

In this case, an Al-Ag-Cu eutectic liquid phase is present during the reaction. The Al-Ag-Cu eutectic has a lower eutectic temperature than Al-Cu eutectic, the Al-Ag-Cu eutectic lowers the energy of the system and thus further promotes the reaction.

In the insulating circuit substrate according to the present invention, it is preferable that a maximum indentation hardness in a region from 10 $\mu$m to 50 $\mu$m from the bonded interface between the copper sheet and the ceramic substrate to a copper sheet side is in a range of 70 mgf/$\mu$m$^2$ or more and 135 mgf/$\mu$m$^2$ or less.

In this case, since the maximum indentation hardness in the region from 10 $\mu$m to 50 $\mu$m from the bonded interface between the copper sheet and the ceramic substrate to the copper sheet side is set to 70 mgf/$\mu$m$^2$ or more, the copper at or in the vicinity of the bonded interface is sufficiently melted during bonding, to form a liquid phase, and the ceramic substrate and the copper sheet are firmly bonded to each other. On the other hand, since the maximum indentation hardness in the above-described region is suppressed to 135 mgf/$\mu$m$^2$ or less, the vicinity of the bonded interface is not harder than necessary, and the generation of cracks during loading of the thermal cycle can be suppressed.

In the insulating circuit substrate according to the present invention, it is preferable that the active metal is Ti.

In this case, a titanium nitride layer or a titanium oxide layer is formed as the active metal compound layer at the bonded interface between the ceramic substrate and the copper sheet, and the ceramic substrate and the copper sheet can be firmly bonded to each other.

In the insulating circuit substrate according to the present invention, it is preferable that a maximum particle size of particles of the active metal compound in the active metal compound layer is 180 nm or less.

In this case, a proportion of a grain boundary region (metal phase) having a relatively low hardness in the active metal compound layer increases, and impact resistance of the active metal compound layer is improved. As a result, it is possible to suppress the generation of cracks in the active metal compound layer, and to suppress peeling of the copper sheet and the ceramic substrate and the generation of cracks in the ceramic substrate.

Effects of Invention

According to the present invention, it is possible to provide a copper/ceramic bonded body and an insulating circuit substrate, which have a high bonding strength and particularly excellent reliability of a thermal cycle.

BRIEF DESCRIPTION OF DRAWINGS

Fig. 1 is a schematic explanatory view of a power module using an insulating circuit substrate according to an embodiment of the present invention.
Fig. 2 is an enlarged explanatory view of a bonded interface between a circuit layer (metal layer) and a ceramic substrate of the insulating circuit substrate according to the embodiment of the present invention.
Fig. 3 is an observation result of the bonded interface between the circuit layer (metal layer) and the ceramic substrate of the insulating circuit substrate according to the embodiment of the present invention.

Fig. 4 is an observation result of the bonded interface between the circuit layer (metal layer) and the ceramic substrate of the insulating circuit substrate according to the embodiment of the present invention.

Fig. 5 is an observation result of the bonded interface between the circuit layer (metal layer) and the ceramic substrate of the insulating circuit substrate according to the embodiment of the present invention.

Fig. 6 is an explanatory view showing a HAADF image of an active metal compound layer at the bonded interface between the circuit layer (metal layer) and the ceramic substrate of the insulating circuit substrate according to the embodiment of the present invention.

Fig. 7 is a flowchart of a production method of the insulating circuit substrate according to the embodiment of the present invention.

Fig. 8 is a schematic explanatory view of the production method of the insulating circuit substrate according to the embodiment of the present invention.

Fig. 9A is an explanatory view of an interfacial reaction in the production method of the insulating circuit substrate according to the embodiment of the present invention.

Fig. 9B is an explanatory view of the interfacial reaction in the production method of the insulating circuit substrate according to the embodiment of the present invention.

Fig. 10 is an explanatory view showing a measurement point of the maximum indentation hardness in the vicinity of a bonded interface in Examples.

## EMBODIMENTS FOR CARRYING OUT THE INVENTION

Hereinafter, an embodiment of the present invention will be described with reference to the accompanying drawings.

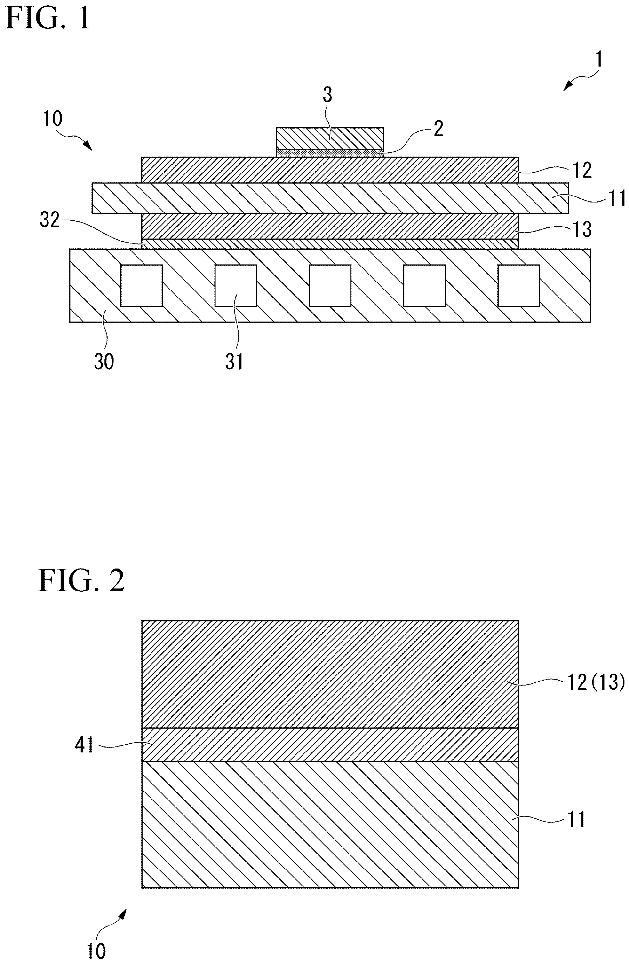

A copper/ceramic bonded body according to the present embodiment is an insulating circuit substrate 10 formed by bonding a ceramic substrate 11 as a ceramic member made of ceramics to a copper sheet 22 (circuit layer 12) and a copper sheet 23 (metal layer 13) as a copper member made of copper or a copper alloy. Fig. 1 shows a power module 1 including the insulating circuit substrate 10 according to the present embodiment.

The power module 1 includes the insulating circuit substrate 10 on which the circuit layer 12 and the metal layer 13 are disposed, a semiconductor element 3 bonded to one surface (upper surface in Fig. 1) of the circuit layer 12 with a bonding layer 2 interposed therebetween, and a heat sink 30 disposed on the other side (lower side in Fig. 1) of the metal layer 13.

The semiconductor element 3 is made of a semiconductor material such as Si. The semiconductor element 3 and the circuit layer 12 are bonded to each other with the bonding layer 2 interposed therebetween.

The bonding layer 2 is made of, for example, a Sn-Ag-based, Sn-In-based, or Sn-Ag-Cu-based solder material.

The heat sink 30 dissipates heat from the above-mentioned insulating circuit substrate 10. The heat sink 30 is made of copper or a copper alloy, and in the present embodiment, the heat sink 30 is made of phosphorus-deoxidized copper. The heat sink 30 is provided with a passage 31 through which a cooling fluid flows.

In the present embodiment, the heat sink 30 and the metal layer 13 are bonded to each other by a solder layer 32 made of a solder material. The solder layer 32 is made of, for example, a Sn-Ag-based, Sn-In-based, or Sn-Ag-Cu-based solder material.

As shown in Fig. 1, the insulating circuit substrate 10 according to the present embodiment includes the ceramic substrate 11, the circuit layer 12 disposed on one surface (upper surface in Fig. 1) of the ceramic substrate 11, and the metal layer 13 disposed on the other surface (lower surface in Fig. 1) of the ceramic substrate 11.

The ceramic substrate 11 is made of aluminum-containing ceramics having excellent insulating properties and heat radiation, and in the present embodiment, the ceramic substrate 11 is made of aluminum nitride (AlN). The thickness of the ceramic substrate 11 is set to be in a range of, for example, 0.2 mm or more and 1.5 mm or less, and in the present embodiment, the thickness is set to 0.635 mm.

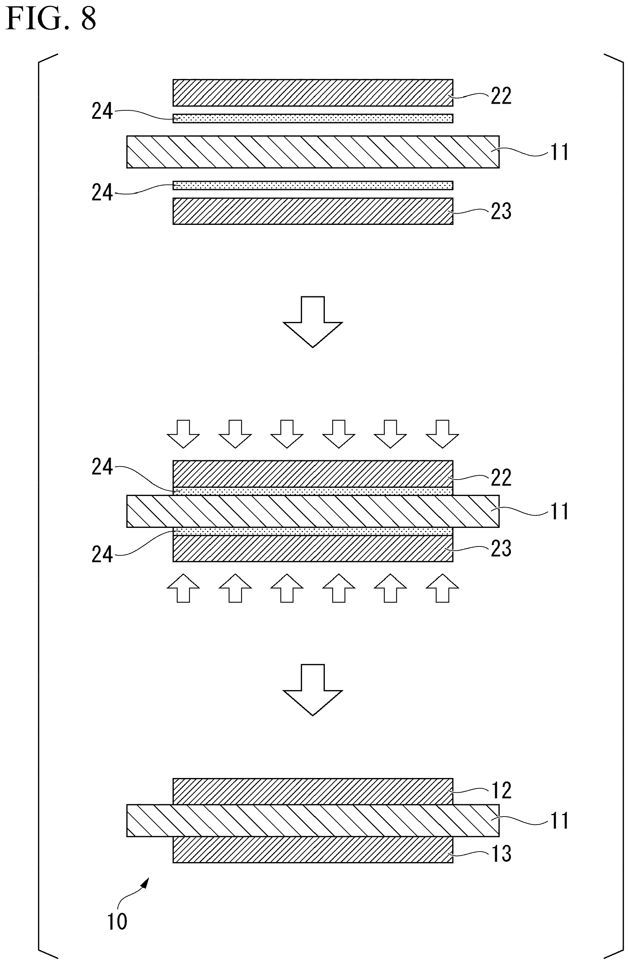

As shown in Fig. 8, the circuit layer 12 is formed by bonding the copper sheet 22 made of copper or a copper alloy to one surface (upper surface in Fig. 8) of the ceramic substrate 11.

In the present embodiment, the circuit layer 12 is formed by bonding the copper sheet 22 made of a rolled plate of oxygen-free copper to the ceramic substrate 11.

The thickness of the copper sheet 22 serving as the circuit layer 12 is set to be in a range of 0.1 mm or more and 1.0 mm or less, and in the present embodiment, the thickness is set to 0.6 mm.

As shown in Fig. 8, the metal layer 13 is formed by bonding the copper sheet 23 made of copper or a copper alloy to the other surface (lower surface in Fig. 8) of the ceramic substrate 11.

In the present embodiment, the metal layer 13 is formed by bonding the copper sheet 23 made of a rolled plate of oxygen-free copper to the ceramic substrate 11.

The thickness of the copper sheet 23 serving as the metal layer 13 is set to be in a range of 0.1 mm or more and 1.0 mm or less, and in the present embodiment, the thickness is set to 0.6 mm.

At the bonded interface between the ceramic substrate 11 and the circuit layer 12 (metal layer 13), as shown in Fig. 2, an active metal compound layer 41 containing an active metal compound that is a compound of one or more active metals selected from Ti, Zr, Nb, and Hf is formed.

The active metal compound layer 41 is formed by reacting an active metal contained in a bonding material with the ceramic substrate 11.

In the present embodiment, Ti is used as the active metal and the ceramic substrate 11 is made of aluminum nitride, so that the active metal compound layer 41 becomes a titanium nitride (TiN) layer.

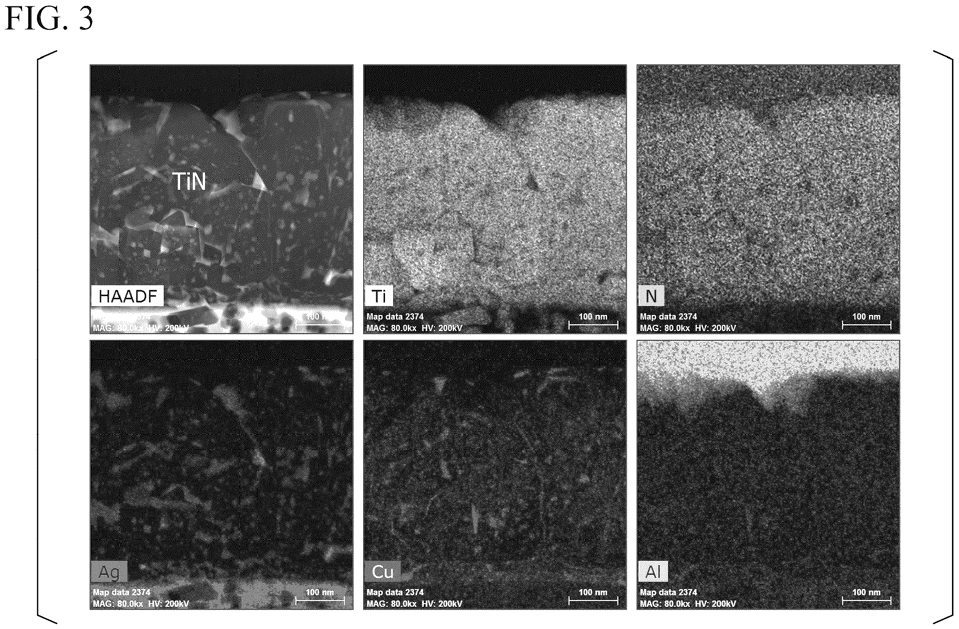

The observation results of the active metal compound layer 41 are shown in Figs. 3 to 6. As shown in Fig. 3, Al and Cu are present in the interior of the active metal compound layer 41. In the present embodiment, Ag contained in the bonding material is also present.

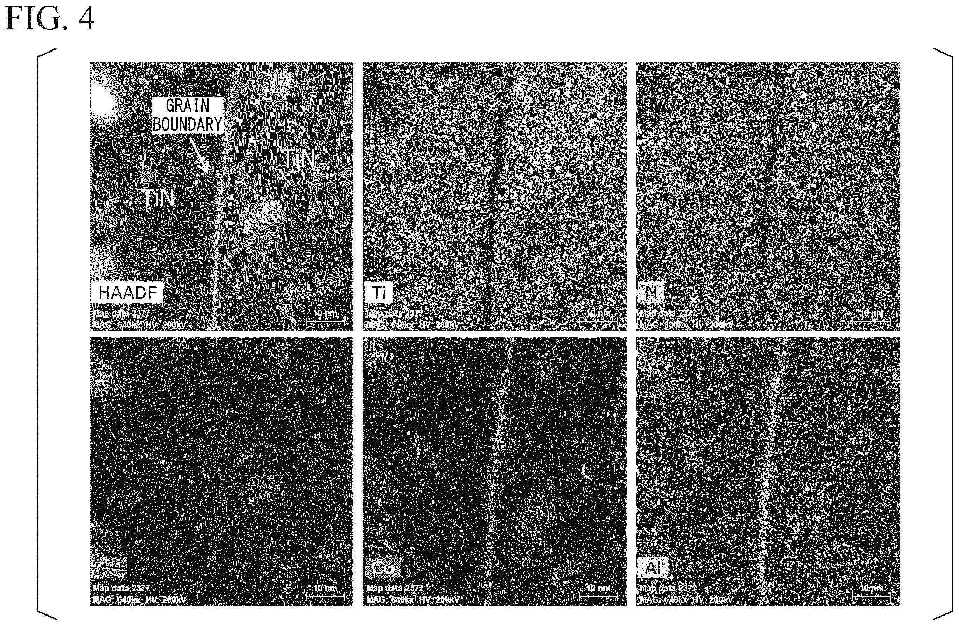

As shown in Fig. 4, Al, Cu, and Ag are present in aggregated state at the grain boundary of the active metal compound (TiN in the present embodiment).

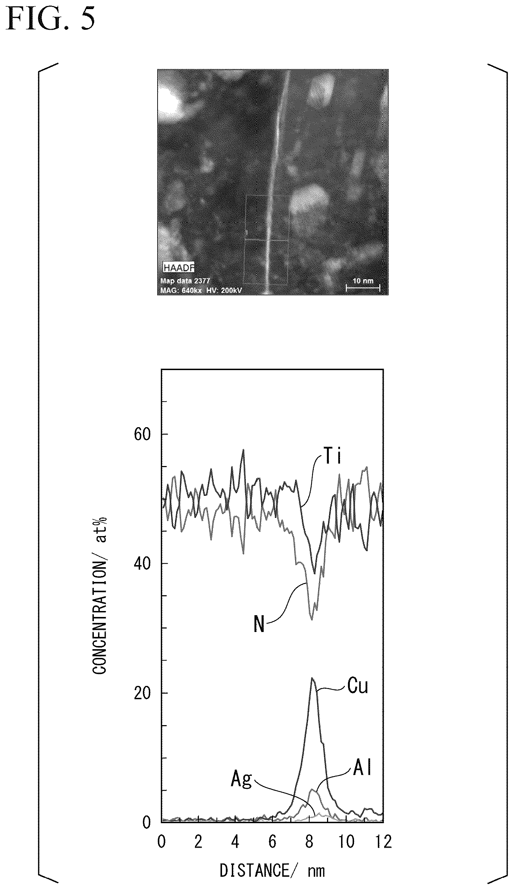

As a result of line analysis of the vicinity of the grain boundary of the active metal compound (TiN in the present embodiment), it is confirmed that the concentration of Al, Cu, and Ag is increased in the grain boundary portion as shown in Fig. 5.

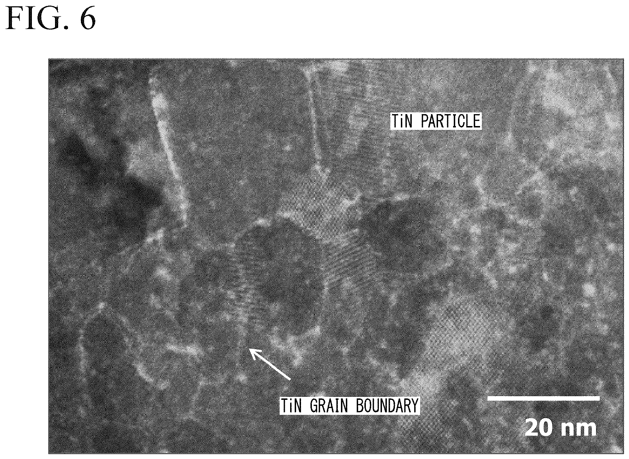

In the present embodiment, as shown in Fig. 6, it is preferable that the maximum particle size of the active metal compound particles in the active metal compound layer 41 is 180 nm or less. That is, it is preferable that the active metal compound layer 41 has a large number of grain boundary regions (metal phases). In Fig. 6, TiN particles are present, and the maximum particle size of the TiN particles is 180 nm or less. The maximum particle size of the active metal compound particles in the active metal compound layer 41 is more preferably 150 nm or less, and still more preferably 120 nm or less. The lower limit may be, for example, 4 nm or more. It is difficult to make the particle size less than 4 nm in production.

In the insulating circuit substrate 10 according to the present embodiment, it is preferable that the maximum indentation hardness in a region from 10 $\mu$m to 50 $\mu$m from the bonded interface between the circuit layer 12 (metal layer 13) and the ceramic substrate 11 to the circuit layer 12 (metal layer 13) side is in a range of 70 mgf/$\mu$m$^2$ or more and 135 mgf/$\mu$m$^2$ or less.

The maximum indentation hardness is more preferably 75 mgf/$\mu$m$^2$ or more, and still more preferably 85 mgf/$\mu$m$^2$ or more. On the other hand, the maximum indentation hardness is more preferably 130 mgf/$\mu$m$^2$ or less, and still more preferably 125 mgf/$\mu$m$^2$ or less.

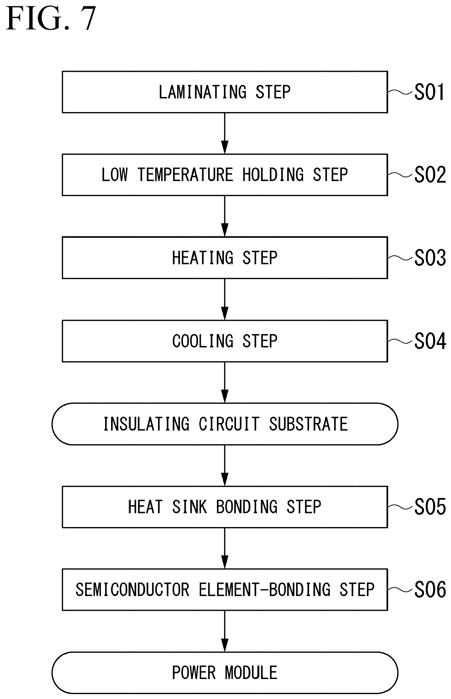

Hereinafter, a method for producing the insulating circuit substrate 10 according to the present embodiment will be described with reference to Figs. 7 and 8.

(Laminating Step S01)

First, the ceramic substrate 11 made of aluminum nitride (AlN) is prepared, and as shown in Fig. 8, an Ag-Ti-based brazing material (Ag-Cu-Ti-based brazing material) 24 is disposed as a bonding material between the copper sheet 22 serving as the circuit layer 12 and the ceramic substrate 11, and between the copper sheet 23 serving as the metal layer 13 and the ceramic substrate 11.

As the Ag-Ti-based brazing material (Ag-Cu-Ti-based brazing material) 24, for example, it is preferable to use a composition containing Cu in an amount of 0 mass% or more and 32 mass% or less, and Ti as an active metal in an amount of 0.5 mass% or more and 20 mass% or less, with a balance being Ag and inevitable impurities. The thickness of the Ag-Ti-based brazing material (Ag-Cu-Ti-based brazing material) 24 is preferably in a range of 2 $\mu$m or more and 10 $\mu$m or less.

(Low Temperature Holding Step S02)

Next, in a state where the ceramic substrate 11 and the copper sheets 22 and 23 are pressed in a lamination direction, the ceramic substrate 11 and the copper sheets 22 and 23 are loaded into a heating furnace in a vacuum or in argon atmosphere, and are heated and held.

A holding temperature in the low temperature holding step S02 is set to be in a temperature range of a eutectic point temperature of Cu and Al or more and lower than a eutectic point temperature of Ag and Cu. In the low temperature holding step S02, a temperature integration value at the above-described holding temperature is in a range of 30 °C·h or higher and 400 °C·h or lower.

A pressing load in the low temperature holding step S02 is preferably in a range of 0.098 MPa or more and 2.94 MPa or less.

(Heating Step S03)

Next, the copper sheets 22 and 23 and the ceramic substrate 11 are heated in a heating furnace in a vacuum atmosphere in a state of being pressed, to melt the Ag-Ti-based brazing material (Ag-Cu-Ti-based brazing material) 24.

A heating temperature in the heating step S03 is in a range of the eutectic point temperature of Ag and Cu or more and 850°C or less. By suppressing the heating temperature low, it is possible to suppress the maximum particle size of the active metal compound particles in the active metal compound layer 41 small. The heating temperature is preferably 845°C or lower, more preferably 835°C or lower, and still more preferably 825°C or lower.

In the heating step S03, a temperature integration value at the above-described heating temperature is in a range of 4 °C·h or higher and 200 °C·h or lower. Preferably, the temperature integral value may be in a range of 4 °C·h or higher and 150 °C·h or lower.

A pressing load in the heating step S03 is in a range of 0.049 MPa or more and 2.94 MPa or less.

(Cooling Step S04)

Then, after the heating step S03, the molten Ag-Ti-based brazing material (Ag-Cu-Ti-based brazing material) 24 is solidified by cooling.

A cooling rate in the cooling step S04 is not particularly limited, and is preferably in a range of 2 °C/min or higher and 10 °C/min or lower.

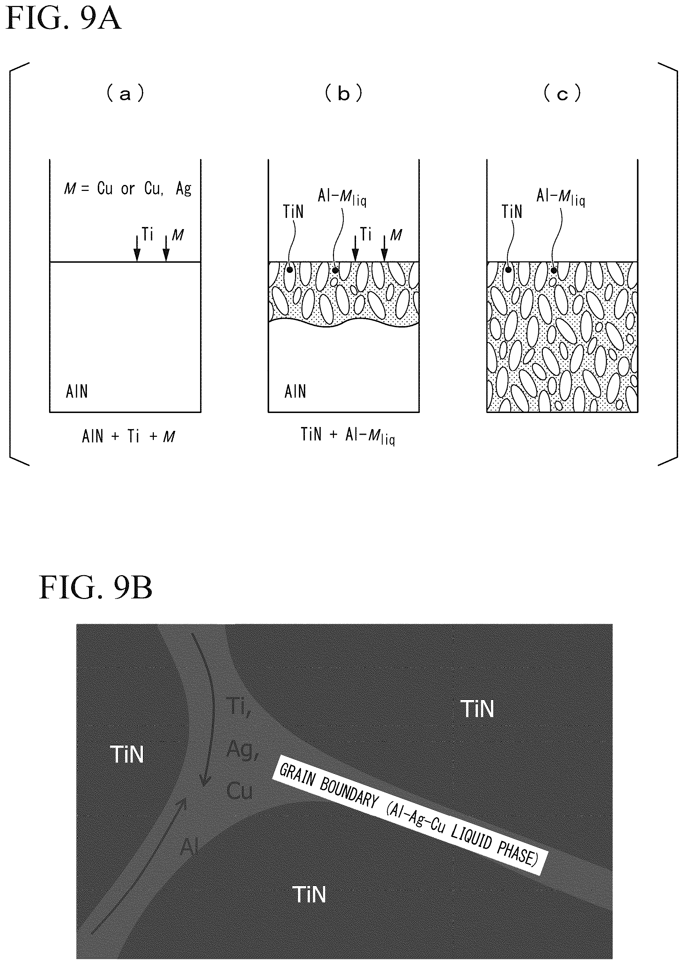

In the above-described low temperature holding step S02, since the temperature is held at a temperature of the eutectic point temperature of Cu and Al or more, Cu in the copper sheets 22 and 23 and the Ag-Ti-based brazing material (Ag-Cu-Ti-based brazing material) 24, and Al produced by the reaction of the ceramic substrate 11 made of AlN with Ti are subjected to a eutectic reaction, to generate a eutectic liquid phase, as shown in Fig. 9A. In this eutectic liquid phase, Ti in the Ag-Ti-based brazing material (Ag-Cu-Ti-based brazing material) 24 reacts with N (nitrogen) in the ceramic substrate 11 to generate TiN. As a result, the active metal compound layer 41 made of TiN is formed in such a manner that the surface of the ceramic substrate 11 is eroded in the order of (a) of Fig. 9A, (b) of Fig. 9A, and (c) of Fig. 9A.

As shown in Fig. 9B, in the active metal compound layer 41, a eutectic liquid phase is present at the grain boundary of the active metal compound (TiN in the present embodiment), and Al on the ceramic substrate 11 side and Ag, Cu, and Ti of the Ag-Ti-based brazing material (Ag-Cu-Ti-based brazing material) 24 diffuse into each other by using the eutectic liquid phase as a diffusion path, to promote the interfacial reaction of the ceramic substrate 11.

As a result, Al, Cu, and Ag are present in aggregated state at the grain boundary of the active metal compound (TiN in the present embodiment).

As described above, the ceramic substrate 11 and the copper sheets 22 and 23 are bonded to each other by the laminating step S01, the low temperature holding step S02, the heating step S03, and the cooling step S04; and thereby, the insulating circuit substrate 10 according to the present embodiment is produced.

(Heat Sink Bonding Step S05)

Next, the heat sink 30 is bonded to the other surface side of the metal layer 13 of the insulating circuit substrate 10.

The insulating circuit substrate 10 and the heat sink 30 are laminated with a solder material interposed therebetween and are loaded into a heating furnace such that the insulating circuit substrate 10 and the heat sink 30 are solder-bonded to each other with the solder layer 32 interposed therebetween.

(Semiconductor Element-Bonding Step S06)

Next, the semiconductor element 3 is bonded to one surface of the circuit layer 12 of the insulating circuit substrate 10 by soldering.

The power module 1 shown in Fig. 1 is produced by the above-described steps.

According to the insulating circuit substrate 10 (copper/ceramic bonded body) of the present embodiment having the above-described configuration, in the active metal compound layer 41 formed at the bonded interface between the circuit layer 12 (metal layer 13) and the ceramic substrate 11, Al and Cu are present at the grain boundary of the active metal compound (TiN), so that the active metal (Ti) contained in the Ag-Ti-based brazing material (Ag-Cu-Ti-based brazing material) 24 which is a bonding material sufficiently reacts with the ceramic substrate 11, and the ceramic substrate 11 and the circuit layer 12 (metal layer 13) are firmly bonded to each other.

In the low temperature holding step S02, since the active metal (Ti) is sufficiently diffused to the ceramic substrate 11 side via a liquid phase (Al-Cu eutectic liquid phase) formed by the reaction, the ceramic substrate 11 and the circuit layer 12 (metal layer 13) can be firmly bonded to each other. Accordingly, reliability of a thermal cycle can be improved.

In the insulating circuit substrate 10 according to the present embodiment, since Ag is present at the grain boundary of the active metal compound in the active metal compound layer 41, an Al-Ag-Cu eutectic liquid phase having a lower eutectic temperature than the Al-Cu eutectic is present during the reaction, so that the energy of the system can be lowered and the reaction can be further promoted.

When the maximum particle size of the active metal compound particles in the active metal compound layer 41 is 180 nm or less, a proportion of the grain boundary region (metal phase) having a relatively low hardness in the active metal compound layer 41 increases, and the impact resistance of the active metal compound layer 41 is improved. Thereby, the generation of cracks in the active metal compound layer 41 can be suppressed. Therefore, even when ultrasonic waves are applied to the insulating circuit substrate 10 (copper/ceramic bonded body) for ultrasonic bonding of a terminal material or the like to the circuit layer 12 (metal layer 13), the peeling of the circuit layer 12 (metal layer 13) from the ceramic substrate 11 and the generation of cracks in the ceramic substrate 11 can be suppressed.

In the insulating circuit substrate 10 according to the present embodiment, when the maximum indentation hardness in a region from 10 $\mu$m to 50 $\mu$m from the bonded interface between the circuit layer 12 (metal layer 13) and the ceramic substrate 11 to the circuit layer 12 (metal layer 13) side is set to 70 mgf/$\mu$m$^2$ or more, the copper at or in the vicinity of the bonded interface is sufficiently melted to generate a liquid phase, and the ceramic substrate 11 and the circuit layer 12 (metal layer 13) are more firmly bonded to each other.

On the other hand, when the maximum indentation hardness is suppressed to 135 mgf/$\mu$m$^2$ or less, the vicinity of the bonded interface is not harder than necessary, and the generation of cracks during loading of the thermal cycle can be suppressed.

EXAMPLES

Hereinafter, results of confirmation experiments performed to confirm the effects of the present invention will be described.

(Example 1)

First, a ceramic substrate (40 mm $\times$ 40 mm $\times$ 0.635 mm) made of the materials shown in Table 1 was prepared.

A copper sheet (37 mm $\times$ 37 mm $\times$ thickness of 0.3 mm) made of oxygen-free copper was bonded to both surfaces of the ceramic substrate under the conditions shown in Table 1 by using an Ag-Cu-based brazing material containing the active metal (composition: 28 mass% of Cu, and 1 mass% of active metal, with the balance being Ag and inevitable impurities, thickness: 6 $\mu$m) shown in Table 1, to obtain an insulating circuit substrate (copper/ceramic bonded body). A degree of vacuum of a vacuum furnace at the time of bonding was set to 5 $\times$ 10$^{-3}$ Pa.

For the obtained insulating circuit substrate (copper/ceramic bonded body), the presence or absence of Al, Cu, and Ag at a grain boundary in an active metal compound layer, the maximum indentation hardness in the vicinity of a bonded interface, and the reliability of the thermal cycle were evaluated as follows.

(Presence or Absence of Al and Cu at Grain Boundary in Active Metal Compound Layer)

Elemental mapping of the grain boundary in the active metal compound layer was acquired at an acceleration voltage of 200 kV and at a magnification of 500000 to 700000 by using a transmission electron microscope (Titan ChemiSTEM manufactured by FEI Company), and when a region in which Al and Cu coexisted was present, determination was made that Al and Cu were "present" at the grain boundary.

(Presence or Absence of Ag at Grain Boundary in Active Metal Compound Layer)

Line analysis was performed on the grain boundary in the active metal compound layer across the grain boundary at an acceleration voltage of 200 kV and at a magnification of 500000 to 700000 by using a transmission electron microscope (Titan ChemiSTEM manufactured by FEI Company).

In a case where the ceramic substrate was AlN, when a total value of Cu, Ag, Al, N, and active metal elements was 100 atomic% and the concentration of Ag was 0.4 atomic% or more, determination was made that Ag was "present" at the grain boundary.

In a case where the ceramic substrate was Al$_2$O$_3$, when a total value of Cu, Ag, Al, O, and active metal elements was 100 atomic% and the concentration of Ag was 0.4 atomic% or more, determination was made that Ag was "present" at the grain boundary.

(Maximum Indentation Hardness in vicinity of Bonded Interface)

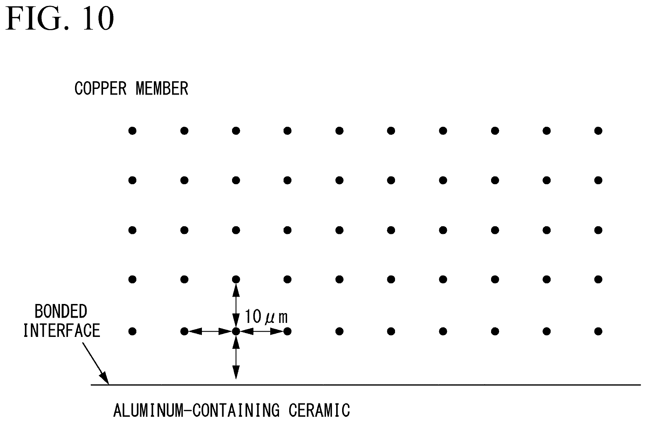

The maximum indentation hardness was measured in a region from 10 $\mu$m to 50 $\mu$m from the bonded interface between the copper sheet and the ceramic substrate to the copper sheet side by using an indentation hardness tester (ENT-1100a manufactured by Elionix Inc.). As shown in Fig. 10, the measurement was performed at intervals of 10 μm, and the measurement was performed at 50 points. The evaluation results are shown in Table 1.

(Reliability of Thermal Cycle)

After the sample was passed through the following atmosphere, the bonded interface between the copper sheet and the ceramic substrate was inspected by SAT inspection, and the presence or absence of ceramic breaking was determined.

$$-78°\text{C} \times 2 \text{ minutes} \leftarrow \rightarrow 350°\text{C} \times 2 \text{ minutes}$$

The number of cycles in which breaking occurred was evaluated. A case where breaking was confirmed in less than 6 times of cycle was evaluated as "C", a case where breaking was confirmed in 6 times or more and less than 8 times of cycle was evaluated as "B", and a case where breaking was not confirmed even in 8 times or more of cycle was evaluated as "A". The evaluation results are shown in Table 1.

Table 1

| | | Ceramic substrate | Active metal | Low temperature holding step | | Heating step | | Active metal compound layer | | | Maximum indentation hardness at bonded interface※ (mgf/$\mu$m²) | Reliability of thermal cycle |
| | | | | Load (MPa) | Temperature integration value (°C·h) | Load (MPa) | Temperature integration value (°C·h) | Material | Grain boundary | | | |
| | | | | | | | | | Al and Cu | Ag | | |
| Invention Example | 1 | AlN | Ti | 2.94 | 400 | 2.94 | 150 | TiN | Present | Present | 70 | A |
| | 2 | AlN | Ti | 0.98 | 203 | 0.49 | 4 | TiN | Present | Present | 135 | A |
| | 3 | AlN | Ti | 1.47 | 55 | 1.47 | 72 | TiN | Present | Present | 112 | A |
| | 4 | Al₂O₃ | Ti | 1.96 | 123 | 0.098 | 96 | Ti-O | Present | Present | 103 | A |
| | 5 | Al₂O₃ | Zr | 1.96 | 250 | 1.96 | 130 | ZrO₂ | Present | Present | 91 | A |
| | 6 | AlN | Zr | 0.98 | 363 | 0.98 | 138 | ZrN | Present | Present | 86 | A |
| | 7 | AlN | Nb | 0.049 | 30 | 0.049 | 4 | NbN | Present | Absent | 142 | B |
| | 8 | Al₂O₃ | Hf | 0.294 | 30 | 0.049 | 4 | HfO₂ | Present | Absent | 139 | B |
| Comparative Example | 1 | AlN | Ti | 0.98 | 18 | 0.49 | 12 | TiN | Absent | Absent | 125 | C |
| | 2 | AlN | Zr | 1.47 | 0 | 1.47 | 2 | ZrN | Absent | Absent | 153 | C |
| | 3 | Al₂O₃ | Ti | 1.96 | 168 | 0.098 | 1.5 | - | - | - | - | - |

※ Maximum indentation hardness in region from 10 $\mu$m to 50 $\mu$m from bonded interface between copper sheet and ceramic substrate to copper sheet side

EP 4 074 678 B1

In Comparative Example 1 in which a temperature integration value in the low temperature holding step was 18 °C h, Al and Cu were not confirmed at the grain boundary of the active metal compound layer, and the reliability of the thermal cycle was "C".

In Comparative Example 2 in which a temperature integration value in the low temperature holding step was 0 °C·h, Al and Cu were not confirmed at the grain boundary of the active metal compound layer, and the reliability of the thermal cycle was "C".

In Comparative Example 3 in which a temperature integration value in the heating step was 1.5 °C-h, the copper sheet and the ceramic substrate could not be sufficiently bonded to each other. Therefore, other evaluations were discontinued.

On the other hand, in Invention Examples 1 to 8 in which Al and Cu were confirmed at the grain boundary of the active metal compound layer, the reliability of the thermal cycle was "B" or "A" regardless of the material of the ceramic substrate and the active metal element.

In particular, Invention Examples 1 to 6 in which the maximum indentation hardness in a region from 10 $\mu$m to 50 $\mu$m from the bonded interface between the copper sheet and the ceramic substrate to the copper sheet side was in a range of 70 mgf/$\mu$m$^2$ or more and 135 mgf/$\mu$m$^2$ or less, the reliability of the thermal cycle was "A", and the reliability of the thermal cycle was particularly excellent.

(Example 2)

Under the conditions shown in Table 2, the copper sheet and the ceramic substrate were bonded to each other by the same procedure as in Example 1 described above to obtain an insulating circuit substrate (copper/ceramic bonded body).

For the obtained insulating circuit substrate (copper/ceramic bonded body), the presence or absence of Al, Cu, and Ag at a grain boundary in an active metal compound layer and the maximum indentation hardness in the vicinity of a bonded interface were evaluated by the same procedure as in Example 1.

The maximum particle size of the active metal compound particles in the active metal compound layer and ultrasonic welding property were evaluated as follows.

(Maximum Particle Size of Active Metal Compound Particles in Active Metal Compound Layer)

The active metal compound layer was observed at a magnification of 500000 by using a transmission electron microscope (Titan ChemiSTEM manufactured by FEI Company), to obtain a HAADF image.

By image analysis of the HAADF image, the equivalent circle diameter of the active metal compound particles was calculated. From the results of image analysis in 10 fields of view, the maximum equivalent circle diameter of the observed active metal compound particles is shown in Table 2 as the maximum particle size.

(Evaluation of Ultrasonic Bonding)

A copper terminal (6 mm × 20 mm × 1.5 mm in thickness) was ultrasonically bonded to the insulating circuit substrate by using an ultrasonic metal bonding machine (60C-904 manufactured by Ultrasonic Engineering Co., Ltd.) under the conditions where a load was 800 N, a collapse amount was 0.7 mm, and a bonding area was 3 mm × 3 mm. 50 copper terminals were bonded at a time.

After bonding, the bonded interface between the copper sheet and the ceramic substrate was inspected by using an ultrasonic flaw detector (FineSAT200 manufactured by Hitachi Solutions, Ltd.). A case where peeling of the copper sheet from the ceramic substrate or ceramic breaking was observed in 5 pieces or more out of 50 pieces was evaluated as "D", a case where peeling of the copper sheet from the ceramic substrate or ceramic breaking was observed in 3 pieces or more and 4 pieces or less out of 50 pieces was evaluated as "C", a case where peeling of the copper sheet from the ceramic substrate or ceramic breaking was observed in 1 piece or more and 2 pieces or less out of 50 pieces was evaluated as "B", and a case where peeling of the copper sheet from the ceramic substrate or ceramic breaking was not observed in all 50 pieces was evaluated as "A". The evaluation results are shown in Table 2.

Table 2

| | | Ceramic substrate | Active metal | Low temperature holding step | | Heating step | | | Active metal compound layer | | | Maximum particle size (nm) | Maximum indentation hardness at bonded interface※ (mgf/$\mu$m$^2$) | Evaluation of ultrasonic bonding |
| | | | | Load (MPa) | Temperature integration value (°C·h) | Load (MPa) | Temperature integration value (°C·h) | Heating temperature (°C) | Material | Grain boundary | | | | |
| | | | | | | | | | | Al and Cu | Ag | | | |
| Invention Example | 11 | AlN | Ti | 0.98 | 203 | 0.49 | 4 | 815 | TiN | Present | Present | 82 | 135 | A |
| | 12 | AlN | Ti | 0.98 | 203 | 0.49 | 35 | 825 | TiN | Present | Present | 91 | 128 | A |
| | 13 | AlN | Ti | 0.98 | 203 | 0.49 | 90 | 835 | TiN | Present | Present | 144 | 107 | B |
| | 14 | AlN | Ti | 1.47 | 55 | 1.47 | 10 | 830 | TiN | Present | Present | 117 | 131 | A |
| | 15 | AlN | Ti | 1.47 | 55 | 1.47 | 72 | 835 | TiN | Present | Present | 139 | 112 | B |
| | 16 | AlN | Ti | 1.47 | 55 | 1.47 | 140 | 845 | TiN | Present | Present | 178 | 84 | C |
| | 17 | AlN | Ti | 1.47 | 55 | 1.47 | 175 | 845 | TiN | Present | Present | 208 | 81 | D |
| | 18 | $Al_2O_3$ | Zr | 0.98 | 250 | 1.96 | 60 | 825 | $ZrO_2$ | Present | Present | 100 | 113 | A |
| | 19 | $Al_2O_3$ | Zr | 0.98 | 250 | 1.96 | 105 | 835 | $ZrO_2$ | Present | Present | 153 | 104 | C |
| | 20 | $Al_2O_3$ | Zr | 1.47 | 250 | 1.96 | 130 | 845 | $ZrO_2$ | Present | Present | 174 | 91 | C |

※ Maximum indentation hardness in region from 10 $\mu$m to 50 $\mu$m from bonded interface between copper sheet and ceramic substrate to copper sheet side

From the comparison among Invention Examples 11 to 17 in which the ceramic substrate was made of AlN and the active metal was Ti and among Invention Examples 18 to 20 in which the ceramic substrate was made of $Al_2O_3$ and the active metal was Zr, it is confirmed that the maximum particle size of the active metal compound particles in the active metal compound layer was reduced; and thereby, the peeling of the copper sheet from the ceramic substrate and the generation of cracks in the ceramic substrate during ultrasonic bonding could be suppressed.

As a result of Examples described above, according to Invention Examples, it was confirmed that it is possible to provide a copper/ceramic bonded body and an insulating circuit substrate, which have a high bonding strength and particularly excellent reliability of a thermal cycle.

Industrial Applicability

According to the present invention, it is possible to provide a copper/ceramic bonded body and an insulating circuit substrate, which have a high bonding strength and particularly excellent reliability of a thermal cycle.

Explanation of Reference Signs

10:    Insulating circuit substrate (copper/ceramic bonded body)
11:    Ceramic substrate (ceramic member)
12:    Circuit layer (copper member)
13:    Metal layer (copper member)
41:    Active metal compound layer

**Claims**

1.    A copper/ceramic bonded body comprising:

   a copper member (13) made of copper or a copper alloy; and
   a ceramic member (11) made of aluminum-containing ceramics, the copper member (13) and the ceramic member (11) being bonded to each other,
   wherein, at a bonded interface between the copper member and the ceramic member, an active metal compound layer (41) containing an active metal compound that is a compound of one or more active metals selected from Ti, Zr, Nb, and Hf is formed on a ceramic member side,
   in the active metal compound layer (41),
   Al and Cu are present at a grain boundary of the active metal compound, and
   a maximum indentation hardness in a region from 10 $\mu$m to 50 $\mu$m from the bonded interface between the copper member (13) and the ceramic member (11) to a copper member side is in a range of 70 mgf/$\mu$m$^2$ or more and 135 mgf/ $\mu$m$^2$ or less.

2.    The copper/ceramic bonded body according to Claim 1,

   wherein, in the active metal compound layer (41),
   Ag is present at the grain boundary of the active metal compound.

3.    The copper/ceramic bonded body according to Claim 1 or 2, wherein the active metal is Ti.

4.    The copper/ceramic bonded body according to any one of Claims 1 to 3, wherein a maximum particle size of particles of the active metal compound in the active metal compound layer (41) is 180 nm or less.

5.    An insulating circuit substrate (10) comprising:

   a copper sheet (23) made of copper or a copper alloy; and
   a ceramic substrate (11) made of aluminum-containing ceramics, the copper sheet (23) being bonded to a surface of the ceramic substrate (11)
   wherein, at a bonded interface between the copper sheet (23) and the ceramic substrate (11) an active metal compound layer (41) containing an active metal compound that is a compound of one or more active metals selected from Ti, Zr, Nb, and Hf is formed on a ceramic substrate side,
in the active metal compound layer (41),
Al and Cu are present at a grain boundary of the active metal compound, and
a maximum indentation hardness in a region from 10 $\mu$m to 50 $\mu$m from the bonded interface between the copper sheet (23) and the ceramic substrate (11) to a copper sheet side is in a range of 70 mgf/$\mu$m$^2$ or more and 135 mgf/ $\mu$m$^2$ or less.

6. The insulating circuit substrate (10) according to Claim 5, wherein, in the active metal compound layer (41), Ag is present at the grain boundary of the active metal compound.

7. The insulating circuit substrate (10) according to Claim 5 or 6, wherein the active metal is Ti.

8. The insulating circuit substrate (10) according to any one of Claims 5 to 7,
wherein a maximum particle size of particles of the active metal compound in the active metal compound layer (41) is 180 nm or less.


**Patentansprüche**

1. Verbundener Kupfer/Keramik-Körper, umfassend:

ein Kupferelement (13) aus Kupfer oder einer Kupferlegierung und ein Keramikelement (11) aus aluminiumhaltiger Keramik, wobei das Kupferelement (13) und das Keramikelement (11) miteinander verbunden sind,
wobei an einer Bindungsgrenzfläche zwischen dem Kupferelement und dem Keramikelement eine Aktivmetallverbindungsschicht (41), die eine Aktivmetallverbindung enthält, die eine Verbindung aus einem oder mehreren Aktivmetallen, ausgewählt aus Ti, Zr, Nb und Hf, ist, auf einer Seite des Keramikelements gebildet ist,
in der Aktivmetallverbindungsschicht (41) Al und Cu an einer Korngrenze der Aktivmetallverbindung vorhanden sind und
eine maximale Eindruckhärte in einem Bereich von 10 $\mu$m bis 50 $\mu$m von der Bindungsgrenzfläche zwischen dem Kupferelement (13) und dem Keramikelement (11) bis zu einer Seite des Kupferelements in einem Bereich von 70 mgf/$\mu$m$^2$ oder mehr und 135 mgf/$\mu$m$^2$ oder weniger liegt.

2. Verbundener Kupfer/Keramik-Körper gemäß Anspruch 1,
wobei in der Aktivmetallverbindungsschicht (41) Ag an der Korngrenze der Aktivmetallverbindung vorhanden ist.

3. Verbundener Kupfer/Keramik-Körper gemäß Anspruch 1 oder 2,
wobei das Aktivmetall Ti ist.

4. Verbundener Kupfer/Keramik-Körper gemäß einem der Ansprüche 1 bis 3,
wobei die maximale Partikelgröße der Partikel aus der Aktivmetallverbindung in der Aktivmetallverbindungsschicht (41) 180 nm oder weniger beträgt.

5. Isolierendes Schaltungssubstrat (10), umfassend:

ein Kupferblech (23) aus Kupfer oder einer Kupferlegierung und
ein Keramiksubstrat (11) aus aluminiumhaltiger Keramik, wobei das Kupferblech (23) mit einer Oberfläche des Keramiksubstrats (11) verbunden ist,
wobei an einer Bindungsgrenzfläche zwischen dem Kupferblech (23) und dem Keramiksubstrat (11) eine Aktivmetallverbindungsschicht (41), die eine Aktivmetallverbindung enthält, die eine Verbindung aus einem oder mehreren Aktivmetallen, ausgewählt aus Ti, Zr, Nb und Hf, ist, auf einer Seite des Keramiksubstrats gebildet ist,
in der Aktivmetallverbindungsschicht (41) Al und Cu an einer Korngrenze der Aktivmetallverbindung vorhanden sind und
eine maximale Eindruckhärte in einem Bereich von 10 $\mu$m bis 50 $\mu$m von der Bindungsgrenzfläche zwischen dem Kupferblech (23) und dem Keramiksubstrat (11) bis zu einer Seite des Kupferblechs in einem Bereich von 70 mgf/$\mu$m$^2$ oder mehr und 135 mgf/$\mu$m$^2$ oder weniger liegt.

6. Isolierendes Schaltungssubstrat (10) gemäß Anspruch 5,
wobei in der Aktivmetallverbindungsschicht (41) Ag an der Korngrenze der Aktivmetallverbindung vorhanden ist.

**7.** Isolierendes Schaltungssubstrat (10) gemäß Anspruch 5 oder 6,
wobei das Aktivmetall Ti ist.

**8.** Isolierendes Schaltungssubstrat (10) gemäß einem der Ansprüche 5 bis 7,
wobei eine maximale Partikelgröße der Partikel der Aktivmetallverbindung in der Aktivmetallverbindungsschicht (41) 180 nm oder weniger beträgt.

**Revendications**

**1.** Corps lié en cuivre/céramique comprenant :

un élément (13) en cuivre fait de cuivre et d'un alliage de cuivre ; et
un élément (11) en céramique fait de céramique contenant de l'aluminium, l'élément (13) en cuivre et l'élément (11) en céramique étant liés l'un à l'autre,
dans lequel, au niveau d'une interface liée entre l'élément en cuivre et l'élément en céramique, une couche (41) de composé de métal actif contenant un composé de métal actif qui est un composé d'un ou plusieurs métaux actifs sélectionnés parmi Ti, Zr, Nb et Hf est formée sur un côté élément en céramique,
dans la couche (41) de composé de métal actif,
Al et Cu sont présents au niveau d'un joint de grain du composé de métal actif, et
une dureté à la pénétration maximale dans une région de 10 $\mu$m à 50 $\mu$m allant de l'interface liée entre l'élément (13) en cuivre et l'élément (11) en céramique à un côté élément en cuivre est dans une plage de 70 mgf/$\mu$m$^2$ ou plus et de 135 mgf/$\mu$m$^2$ ou moins.

**2.** Corps lié en cuivre/céramique selon la revendication 1,
dans lequel, dans la couche (41) de composé de métal actif, Ag est présent au niveau du joint de grain du composé de métal actif.

**3.** Corps lié en cuivre/céramique selon la revendication 1 ou la revendication 2, dans lequel le métal actif est Ti.

**4.** Corps lié en cuivre/céramique selon l'une quelconque des revendications 1 à 3,
dans lequel une taille de particule maximale de particules du composé de métal actif dans la couche (41) de composé de métal actif est de 180 nm ou moins.

**5.** Substrat (10) de circuit isolant comprenant :

une feuille (23) en cuivre faite de cuivre ou d'un alliage de cuivre ; et
un substrat (11) en céramique fait de céramique contenant de l'aluminium, la feuille (23) en cuivre étant liée à une surface du substrat (11) en céramique
dans lequel, au niveau d'une interface liée entre la feuille (23) en cuivre et le substrat (11) en céramique, une couche (41) de composé de métal actif contenant un composé de métal actif qui est un composé d'un ou plusieurs métaux actifs sélectionnés parmi Ti, Zr, Nb et Hf est formée sur un côté substrat en céramique,
dans la couche (41) de composé de métal actif,
Al et Cu sont présents au niveau d'un joint de grain du composé de métal actif, et
une dureté à la pénétration maximale dans une région de 10 $\mu$m à 50 $\mu$m allant de l'interface liée entre la feuille (23) en cuivre et le substrat (11) en céramique à un côté feuille en cuivre est dans une plage de 70 mgf/$\mu$m$^2$ ou plus et de 135 mgf/$\mu$m$^2$ ou moins.

**6.** Substrat (10) de circuit isolant selon la revendication 5,
dans lequel, dans la couche (41) de composé de métal actif, Ag est présent au niveau du joint de grain du composé de métal actif.

**7.** Substrat (10) de circuit isolant selon la revendication 5 ou la revendication 6, dans lequel le métal actif est Ti.

**8.** Substrat (10) de circuit isolant selon l'une quelconque des revendications 5 à 7,
dans lequel une taille de particule maximale de particules du composé de métal actif dans la couche (41) de composé de métal actif est de 180 nm ou moins.

FIG. 1

FIG. 2

FIG. 3

FIG. 4

# FIG. 5

FIG. 6

# FIG. 7

```
┌─────────────────────────────────────┐
│         LAMINATING STEP             │ ～S01
└─────────────────────────────────────┘
                  │
                  ▼
┌─────────────────────────────────────┐
│     LOW TEMPERATURE HOLDING STEP    │ ～S02
└─────────────────────────────────────┘
                  │
                  ▼
┌─────────────────────────────────────┐
│           HEATING STEP              │ ～S03
└─────────────────────────────────────┘
                  │
                  ▼
┌─────────────────────────────────────┐
│           COOLING STEP              │ ～S04
└─────────────────────────────────────┘
                  │
                  ▼
(     INSULATING CIRCUIT SUBSTRATE     )
                  │
                  ▼
┌─────────────────────────────────────┐
│       HEAT SINK BONDING STEP        │ ～S05
└─────────────────────────────────────┘
                  │
                  ▼
┌─────────────────────────────────────┐
│  SEMICONDUCTOR ELEMENT-BONDING STEP │ ～S06
└─────────────────────────────────────┘
                  │
                  ▼
(           POWER MODULE              )
```

## FIG. 8

# FIG. 9A

(a)

$M$ = Cu or Cu, Ag

↓Ti ↓$M$

AlN

AlN + Ti + $M$

(b)

TiN   Al–$M_{liq}$   Ti   $M$

AlN

TiN + Al–$M_{liq}$

(c)

TiN   Al–$M_{liq}$

# FIG. 9B

TiN

TiN

TiN

Ti, Ag, Cu

Al

GRAIN BOUNDARY (Al–Ag–Cu LIQUID PHASE)

# FIG. 10

COPPER MEMBER

BONDED INTERFACE

10 $\mu$ m

ALUMINUM–CONTAINING CERAMIC

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019224214 A
- JP 2020169086 A
- JP H04162756 A
- JP 3211856 B
- JP 5757359 B
- US 2016221305 A1